# EUROPÄISCHE PATENTSCHRIFT

(11) **EP 1 226 348 B1**
(45) Veröffentlichungstag und Bekanntmachung des Hinweises auf die Patenterteilung: **18.08.2004**
(21) Anmeldenummer: 00987071.8
(22) Anmeldetag: 03.11.2000
(51) Int. Cl.: F02D 41/20, H01L 41/04

(54) **ANSTEUEREINHEIT FÜR EIN KAPAZITIVES STELLGLIED**
CONTROL UNIT FOR A CAPACITIVE ACTUATOR
UNITE DE COMMANDE POUR ELEMENT DE REGLAGE CAPACITIF

(30) Priorität: 03.11.1999 DE 19952950
(43) Veröffentlichungstag der Anmeldung: 31.07.2002
(73) Patentinhaber: SIEMENS AKTIENGESELLSCHAFT, 80333 München (DE)
(72) Erfinder: CHEMISKY, Eric, 67630 Lauterbourg (FR); KAPPEL, Andreas, 85649 Brunnthal (DE); GOTTLIEB, Bernhard, 81739 München (DE); BAUSEWEIN, Andreas, 85416 Langenbach (DE); MEIXNER, Hans, 85540 Haar (DE)
(86) Internationale Anmeldenummer: PCT/DE2000/003863
(87) Internationale Veröffentlichungsnummer: WO 2001/033061

(56) Entgegenhaltungen:
- DE-A- 19 734 895
- GB-A- 2 334 623
- JP-A- 2 176 121
- US-A- 4 749 897
- US-A- 5 543 679
- PATENT ABSTRACTS OF JAPAN vol. 017, no. 126 (M-1381), 17. März 1993 (1993-03-17) -& JP 04 308338 A (NIPPONDENSO CO LTD), 30. Oktober 1992 (1992-10-30)
- PATENT ABSTRACTS OF JAPAN vol. 015, no. 194 (M-1114), 20. Mai 1991 (1991-05-20) & JP 03 050360 A (NIPPONDENSO CO LTD), 4. März 1991 (1991-03-04)

## Beschreibung

Die Erfindung betrifft eine Vorrichtung zum variablen Ansteuern wenigstens eines kapazitiven Stellgliedes, insbesondere eines Piezo-Stellgliedes für einen Kraftstoffinjektor in einer Brennkraftmaschine, gemäß dem Oberbegriff des Anspruches 1.

Die in den letzten Jahren ständig strenger werdenden Abgasnormen für Motoren haben in der Kraftfahrzeugindustrie die Entwicklung von Kraftstoffinjektoren mit schnellen, verzögerungsfrei ansprechenden kapazitiven Stellgliedern ausgelöst. Hierbei haben sich vor allem Piezo-Antriebe als vorteilhaft erwiesen. Um bei Piezo-Antrieben den erforderlichen Hub einer Düsennadel im Kraftstoffinjektor erreichen zu können, ist das Piezoelement im Allgemeinen aus einem Stapel von Piezo-Keramikscheiben zusammengesetzt, die über eine elektrische Parallelschaltung betrieben werden, um die für einen ausreichenden Nadelhub notwendigen hohen Feldstärken erreichen zu können. Ein solcher Vielschicht-Piezoaktor stellt dabei für die zur Steuerung eingesetzte elektronische Endstufe eine starke kapazitive Last dar, die in einer sehr kurzen Zeitspanne auf eine Sollspannung aufgeladen und anschließend wieder entladen werden muss. Um insbesondere die strengen Abgasgrenzwerte einhalten zu können, muss die Endstufe gewährleisten, dass der Piezoaktor so angesteuert wird, dass die eingespritzte Kraftstoffmenge von Einspritzvorgang zu Einspritzvorgang exakt reproduzierbar bleibt. Außerdem soll die Endstufe den Piezoaktor so ansteuern können, dass neben der Haupteinspritzung kleinste Kraftstoffmengen vor bzw. nach dieser Haupteinspritzung vom Kraftstoffinjektor in den Brennraum abgegeben werden.

Aus Patent Abstracts of Japan vol. 017, no.126(M-1381), 17. März 1993-&JP04308338 A(Nippondenso Co Ltd)1992-10-30 ist ei ne Vorrichtung zum Laden eines kapazitiven Stellgliedes mittels eines Transformators bekannt, wobei der Ladestrom nach Erreichen eines vorgegebenen Werts durch Pulsweitenmodulation konstant gehalten wird und die Entladung ungeregelt erfolgt.

In US 5,543,679 ist eine Steuerschaltung für ein Piezostellglied beschrieben, wobei bei einem Ladevorgang die in einem Kondensator gespeicherte Energie mittels eines Transformators in einem Umschwingvorgang auf das Stellglied übertragen wird und beim Entladen des Stellgliedes entweder über eine Drossel vernichtet oder über einen weiteren Transformator in den Kondensator zurückgespeichert wird.

Die US 4,749,897 offenbart eine Steuerschaltung für ein Piezostellglied, bei welcher bei einem Ladevorgang ein vorgegebener Energiebetrag mittels eines Transformators in einem Umschwingvorgang auf das Stellglied übertragen wird und dieses ungeregelt wieder entladen wird.

Bei piezoelektrischen Kraftstoffinjektoren werden zur Steuerung vorzugsweise elektronische Endstufen eingesetzt, die nach dem Prinzip eines LC-Schwingkreises arbeiten, bei denen der Piezoaktor den Kondensator darstellt. Bei diesen Endstufen erfolgt der Ladeprozess des Piezoaktors als Umschwingvorgang der Ladung aus einer Ladungsquelle über eine Umladungsspule zum Piezoaktor, wobei die Induktivität der Umladespule zusammen mit den Kapazitäten der Ladungsquelle und des Piezoaktors, die Zeitkonstante für den Lade- bzw. Entladevorgang, d. h. für die Lade- bzw. Entladezeit bestimmt. Eine solche Endstufe ist u. a. in der US 5,130,598 beschrieben.

Bei den bekannten Endstufen ist es jedoch erforderlich, dass die Ladungsquelle bei LC-Gliedern wenigstens eine der Hälfte des maximalen Stellgliedspannung entsprechende Spannung liefern kann, was sie sehr kostenintensiv macht. Weiterhin wird der Piezoaktor immer auf eine Nominalspannung aufgeladen, so dass schnelle Lade- und Entladevorgänge notwendig sind, um die gewünschten kleinen Kraftstoffmengen über den Kraftstoffinjektor einspritzen zu können. Solche schnellen Lade- und Entladevorgänge bei hohen Ladeströmen führen jedoch zu einer großen Belastung der Piezo-Keramik und darüber hinaus zu einer starken Anregung der Resonanzfrequenzen des Kraftstoffinjektors, was zu einer hohen Schallentwicklung führen kann.

Aufgabe der vorliegenden Erfindung ist es, eine Vorrichtung zum variablen Ansteuern eines kapazitiven Stellgliedes, insbesondere eines Piezoaktors zu schaffen, bei der mittels einer einfachen und kostengünstigen Schaltung beliebige Verläufe der Lade- bzw. Entladespannung des kapazitiven Stellgliedes möglich sind.

Diese Aufgabe wird durch die Merkmale des Anspruchs 1 gelöst. Bevorzugte Ausführungsformen sind in den abhängigen Ansprüchen angegeben.

Die erfindungsgemäße Vorrichtung zeichnet sich durch einen Fly-Back-Konverter mit einem Transformator aus, der es ermöglicht, die bei einem Ladevorgang eines kapazitiven Stellgliedes, insbesondere eines Piezoaktors eingespeiste elektrische Energie beim Entladen abhängig vom Wirkungsgrad des Piezoaktors größtenteils zurückzugewinnen, im Konverter zwischenzuspeichern und beim nachfolgenden Ladevorgang z. B. des nächsten kapazitiven Stellgliedes wiederzuverwenden. Die erfindungsgemäße Vorrichtung hat weiter den Vorteil, dass eine Energiequelle nur eine wesentlich geringere Spannung als die am Stellglied benötigte Spannung erzeugen muss, wobei sich die Lade- und Entladedauer und die Spannung am Stellglied, um einen bestimmten Hub zu erzeugen, beliebig festlegen lassen. Bei der erfindungsgemäßen Vorrichtung wird der Schalter der Lade- bzw. Entladeeinrichtung jeweils mit einem pulsweiten-modulierten Signal in einen leitenden Zustand geschaltet, wobei das Tastverhältnis des pulsweiten-modulierten Signals so bestimmt wird, dass der Schalter so lange leitend bleibt, bis eine Vergleichseinrichtung feststellt, dass der am Schalter gemessene Stromwert einem Referenzstromwert entspricht. Durch diese Ausgestaltung lässt sich der zeitliche Verlauf der Lade- bzw. Entladespannung beliebig ausformen, wobei insbesondere der Spannungsverlauf sich dahingehend optimieren lässt, dass die Schallentwicklung durch das kapazitive Stellglied minimiert ist.

Gemäß einer bevorzugten Ausführungsform wird als Schalter für die Lade- bzw. Entladeeinrichtung jeweils ein Transistor eingesetzt, wobei der Ladetransistor der Ladeeinrichtung bevorzugt ein selbstsperrender Feldeffekttransistor ist, der sich durch eine niedrige Verlustleistung auszeichnet, und wobei der Schalter der Entladeeinrichtung vorzugsweise ein Bipolartransistor mit isoliertem Gate ist, der eine hohe Durchbruchspannung besitzt.

Gemäß einer weiteren bevorzugten Ausführungsform wird das Referenzsignal über ein Hochpassfilter erzeugt, der einen von einem konstanten Wert abweichenden Referenzsignalverlauf ermöglicht. Das Hochpassfilter kann dabei als RC-Glied zum Erzeugen eines logarithmischen Verlaufs der Spannung am kapazitiven Stellglied oder als LC-Glied zum Erzeugen eines sinusförmigen Verlaufs der Spannung am kapazitiven Stellglied ausgestaltet sein. Alternativ kann der Referenzsignalgeber auch einen Digital/Analog-Wandler aufweisen, der von einem Prozessor angesteuert wird, um einen beliebigen Referenzsignalverlauf zu erzeugen.

Die Erfindung wird im Folgenden anhand der Zeichnungen näher erläutert. Es zeigen:
- Figur 1: ein Prinzipschaltbild einer ersten Ausführungsform der erfindungsgemäßen Vorrichtung mit einer Ladeeinrichtung;
- Figur 2: ein Diagramm der Signalverläufe in der Vorrichtung nach Figur 1 für ein konstantes Referenzsignal;
- Figur 3: ein Diagramm der Signalverläufe bei einem mit einem RC-Glied erzeugten Referenzsignal;
- Figur 4: ein Diagramm der Signalverläufe bei einem mit einem LC-Glied erzeugten Referenzsignal;
- Figur 5A: ein Prinzipschaltbild einer zweiten Ausführungsform der erfindungsgemäßen Vorrichtung mit einer Ladeund einer Entladeeinrichtung; und
- Figur 5B: einen digitalen Referenzsignalgeber, wie er bei der in Figur 5A gezeigten Ausführungsform eingesetzt wird.

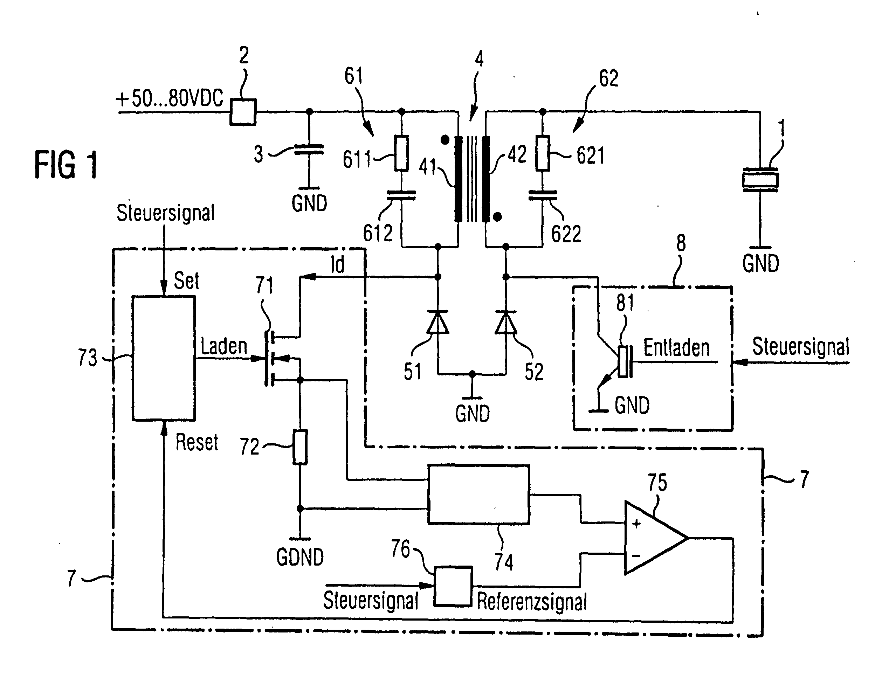

Die in Figur 1 als Prinzipschaltung dargestellte Vorrichtung zum variablen Ansteuern eines kapazitiven Stellgliedes wird in der vorgestellten Ausführungsform als Endstufe zum Ansteuern eines Piezoelements 1 eingesetzt. Die Endstufe wird von einer Energiequelle versorgt, die in der gezeigten Ausführungsform aus einem von einer Bordnetzspannung von 50 V bis 80 V gespeisten DC/DC-Wandler 2 mit einstellbarer Ausgangsspannung besteht, der einen Ladekondensator 3 auf die jeweils gewünschten Ausgangsspannung auflädt.

Parallel zum Ladekondensator 3 ist in der Endstufe eine Reihenschaltung aus der Primärspule 41 eines Transformators 4 und einer ersten Freilaufdiode 51, die vom Bezugspotential GND zur Primärspule 41 hin stromleitend ist, ausgeführt. Parallel zur Primärspule 41 des Transformators 4 ist weiterhin eine erste Snubber-Schaltung 61 angeordnet, die aus einer Reihenschaltung eines Widerstandes 611 und eines Kondensators 612 besteht. Diese erste Snubber-Schaltung 61 dient dazu, die durch Streuinduktivitäten des Transformators 4 in der Primärspule 41 induzierten Spannungsspitzen zu eliminieren.

Parallel zur ersten Freilaufdiode 51 ist eine Ladeeinrichtung 7 geschaltet. Die Ladeeinrichtung 7 weist eine Reihenschaltung aus einem als Schalter dienenden Ladetransistor 71 und einer nachgeordneten, als Strommesswiderstand 72 ausgebildeten Messeinrichtung 71 auf. Der Ladetransistor 71 ist in der gezeigten Ausführungsform ein selbstsperrender MOSFET, dessen Source in Reihe mit der Primärspule 41 geschalten ist. Das Drain des MOSFETs ist über den Strommesswiderstand 72 mit dem Bezugspotential GND verbunden. Das Gate des Ladetransistors 71 wird von einem Lade-Flip-Flop 73 angesteuert.

Die am Strommesswiderstand 72 abfallende Spannung wird über ein Tiefpassfilter 74 abgegriffen und in einen als Vergleichseinrichtung eingesetzten Komparator 75 eingespeist, der daraus den über den Ladetransistor 71 abfallenden Strom bestimmt. Das Tiefpassfilter 74 dient dazu, Stromspitzen, die sich durch die Schaltvorgänge des Ladetransistors 71 ergeben, auszufiltern. Der Komparator 75 wird weiterhin von einem Referenzsignalgeber 76 mit einem Referenzsignal versorgt, das vom Komparator 75 mit dem gemessenen Stromwert verglichen wird. Der Referenzsignalgeber 76 wird dabei über ein Ladesteuersignal angestrengt. Der Lade-Flip-Flop 73 zum Ansteuern des Gate des Ladetransistors 71 wird immer von einem pulsweiten-modulierten Steuersignal getriggert und vom Komparator 75 zurückgesetzt.

Die Sekundärspule 42 des Transformators 4 ist gegenläufig zur Primärspule 41 gewickelt und auf der einen Seite an das als kapazitives Stellglied wirkende Piezoelement 1 angeschlossen. Auf der anderen Seite der Sekundärspule 42 des Transformators 4 ist eine zweite Freilaufdiode 52 angeschlossen, die vom Bezugspotential GND zur Sekundärspule 42 hin stromleitend ist. Parallel zur Sekundärspule 42 des Transformators 4 ist eine zweite Snubber-Schaltung 62 angeordnet, die sich aus einem Widerstand 621 und einem Kondensator 622 zusammensetzt. Die zweite Snubber-Schaltung 62 dient dazu, die in der Sekundärspule 42 des Transformators 4 aufgrund von Streuinduktivitäten induzierten Spannungspitzen zu unterdrücken. Parallel zur zweiten Freilaufdiode 52 ist eine Entladeeinrichtung 8 geschaltet. Der Aufbau (nicht gezeigt) der Entladeeinrichtung 8 ist dabei vorzugsweise symmetrisch zu der Ladeeinrichtung 7, wobei jedoch als Entladetransistor 81 vorzugsweise ein Bipolartransistor mit isoliertem Gate eingesetzt wird, der sich durch eine hohe Durchbruchsspannung auszeichnet.

Die Steuersignale der Ladeeinrichtung 7 und der Entladeeinrichtung 8 werden von einer nicht dargestellten Steuerschaltung ausgegeben, die Teil eines Motorsteuergeräts sein kann.

Die in Figur 1 gezeigte Endstufe für das Piezoelement 1 stellt einen Fly-Back-Konverter dar, bei dem die bei einem Ladevorgang in das Piezoelement 1 eingespeiste elektrische Energie beim Entladen im Wesentlichen zurückgewonnen, im Schaltnetzteil zwischengespeichert und für den folgenden Schaltvorgang verwendet werden kann.

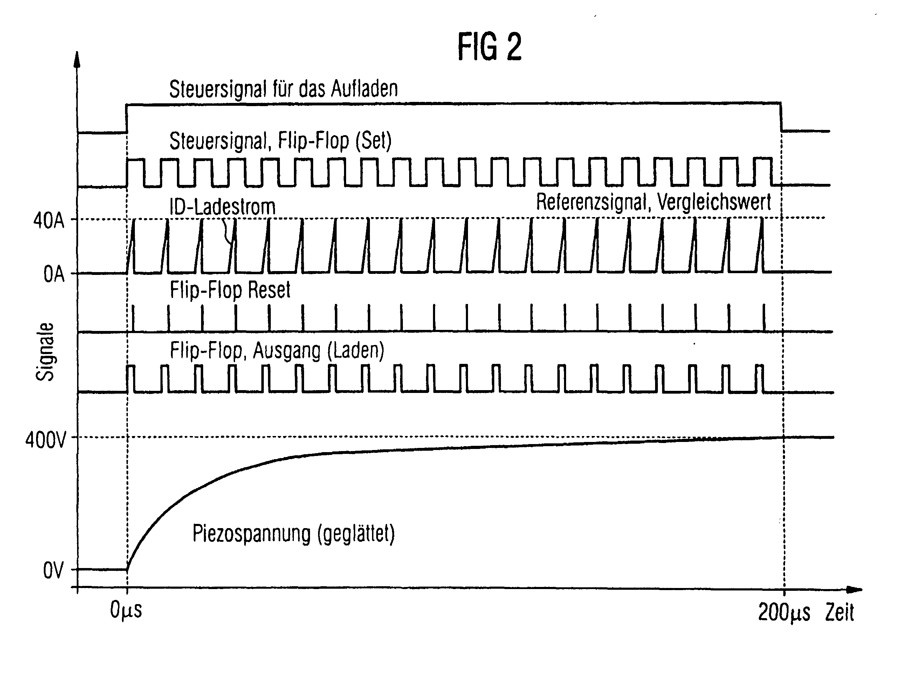

Die in Figur 1 dargestellte Endstufe für das Piezoelement 1 arbeitet dabei wie folgt:
In einem Ausgangszustand ist das Piezoelement 1 entladen und sowohl der Ladetransistor 71 als auch der Entladetransistor 81 befinden sich in einem nicht leitenden Zustand. Weiterhin ist der Ladekondensator 3 auf eine vorgegebene Ausgangsspannung des DC/DC-Wandlers 2 aufgeladen. Wenn das Piezoelement 1 geladen werden soll, wird die Ladeeinrichtung 7 von der Steuereinrichtung (nicht gezeigt) mit den Lade-Steuersignalen angesteuert. Die Ansteuersignale für den Referenzsignalgeber 76 und den Lade-Flip-Flop 73 sind in Figur 2 dargestellt. Weiterhin ist in Figur 2 der während des Ladevorgangs am Strommesswiderstand 72 gemessene Ladestrom und das vom Referenzsignalgeber 76 erzeugte Referenzsignal dargestellt. Außerdem sind das vom Komparator 75 an den Lade-Flip-Flop 73 ausgegebene Reset-Signal sowie das vom lade-Flip-Flop 73 an den Ladetransistor 71 ausgegebene Ladesignal und die daraus resultierende Spannung am Piezoelement 1 gezeigt.

Beim Aufladen wird der Lade-Flip-Flop 73 mit einem Steuersignal in Form eines pulsweiten-modulierten Signals mit einer vorgegebenen Frequenz, typischerweise im Bereich von 100 kHz, und einem vorgegebenen Tastverhältnis, vorzugsweise 50 %, angesteuert. Das pulsweiten-modulierte Signal setzt den Lade-Flip-Flop 73 mit jedem Puls leitend, wodurch vom Lade-Flip-Flop 73 auf das Gate des Ladetransistors 71 ein gepulstes Ladesignal ausgegeben wird. Durch dieses gepulste Ladesignal wird der Ladetransistor 71 leitend geschaltet, so dass ein Ladestrom Id aus dem Ladekondensator 3 über die Primärspule 41 und den Ladetransistor 71 fließt. Der Ladestrom Id steigt dabei wegen der induktiven Last der Primärspule 41 des Transformators 4 linear an. Dieser Ladestrom Id wird über die am Strommesswiderstand 72 abfallende Spannung vom Komparator 75 abgegriffen, wobei das Tiefpassfilter 74 Stromspitzen, die durch den Schaltvorgang des Ladetransistors 71 erzeugt werden, unterdrückt.

Der Komparator 75 vergleicht den gemessenen Stromwert mit einem Referenzstromwert, der vom Referenzsignalgeber 76 während des Aufladevorgangs an den Komparator 75 angelegt wird. In der in Figur 2 gezeigten Ausführungsform ist dieses Referenzsignal auf einen konstanten Wert festgelegt. Stellt der Komparator 75 fest, dass der gemessene Ladestrom Id dem vorgegebenen Referenzwert entspricht, wird vom Komparator 75 an den Lade-Flip-Flop 73 ein Signal ausgegeben, das den Lade-Flip-Flop 73 zurücksetzt. Das Zurücksetzen des Lade-Flip-Flop 73 bewirkt, dass das vom Lade-Flip-Flop 73 auf das Gate des Ladetransistors 71 ausgegebene Ladesignal unterbrochen wird. Der Ladetransistor 71 sperrt dann wieder und unterbricht damit den Ladestrom Id so lange bis der Lade-Flip-Flop 73 durch das nächste Ansteuersignal neu getriggert wird.

Durch die Änderung des Ladestroms Id in der Primärspule 41 des Transformators 4, insbesondere beim Unterbrechen des Ladestroms, wird in der Sekundärspule 42 des Transformators 4 eine dem Windungsverhältnis der Primärspule 41 zur Sekundärspule 42 entsprechende impulsförmige Spannung erzeugt, die von einem Filter (nicht gezeigt) geglättet wird. Bei der in Figur 2 gezeigten Ausführungsform wird dabei aufgrund des konstanten Referenzsignals ein pro Ladestrompuls konstanter Energiepuls in der Sekundärspule 42 des Transformators 4 erzeugt. Diese konstanten Energiepulse laden das Piezoelement 1 auf, bis am Ende der Aufladezeit die gewünschte Piezo-Spannung erreicht ist. Der Sekundärstromkreis mit der Sekundärspule 42 wird beim Laden des Piezoelements 1 dabei über die Freilaufdiode 52 geschlossen.

Das Entladen des Piezoelements 1 erfolgt dann ebenfalls mit pulsweiten-modulierten Signalen der Entladeeinrichtung 8, wobei der als Bipolartransistor mit isoliertem Gate ausgebildete Entladetransistor 81 pulsförmig leitend und nicht-leitend gesteuert wird, wodurch die Spannung des Piezoelements 1 bis auf Null absinkt. Die Entladeeinrichtung 8 kann dabei analog zur Ladeeinrichtung 7 aufgebaut sein mit einem Strommesswiderstand, einem Tiefpassfilter, einem Komparator, einem Referenzsignalgeber und einem Flip-Flop, um das Tastverhältnis der Ansteuerung des Entladetransistors 81 über eine Messung des Entladestroms im Sekundärkreis des Transformators 4 zu bestimmen. Durch das Ändern des Entladestroms über die Ansteuerung des Entladetransistors 81 wird ein Teil der Entladeenergie auf die Primärseite des Transformators 4 zurück übertragen und in den Ladekondensator 3 rückgespeichert. Der Primärstromkreis mit dem Ladekondensator 3 und der Primärspule 41 des Transformators 4 schließt sich dabei über die Freilaufdiode 51.

Der in Figur 2 gezeigte wurzelförmige Verlauf der Ladespannung ermöglicht es, das Piezoelement 1 mit Ladepulsen konstanter Energie aufzuladen, so dass Peakströme im Piezo-Antrieb vermieden werden. Der zeitliche Verlauf der Ladespannung kann dabei dahingehend optimiert sein, dass eine Schallentwicklung am Piezo-Antrieb unterdrückt wird.

Durch die Snubber-Schaltungen 61, 62 wird gewährleistet, dass Spannungsspitzen aufgrund von Streuinduktivitäten in der Primärspule 41 bzw. der Sekundärspule 42, die zu Überspannungen führen könnten, verhindert werden. Die Snubber-Schaltungen 61, 62 könnten dabei auch, statt parallel zu den Spulen 41, 42 des Tranformators 4, parallel zur Ladeeinrichtung 7 bzw. Entladeeinrichtung 8 angeordnet sein. Weiterhin besteht die Möglichkeit, statt der Freilaufdioden 51, 52 den Primär- bzw. Sekundärstromkreis bei einer Spannungsinduktion über Transistoren synchron zu schließen. Der als Ladetransistor 71 in der Ladeeinrichtung 7 verwendete selbstsperrende MOSFET zeichnet sich durch einen geringen Widerstand beim Stromfluss zwischen Drain und Source aus. Hierdurch werden Verluste im Ladetransistor, die sich aufgrund der hohen Ströme beim Ladevorgang ergeben könnten, klein gehalten. Statt des verwendeten MOSFETs besteht jedoch auch die Möglichkeit andere Transistorbauelemente oder grundsätzlich andere Schalterformen einzusetzen. Dies gilt auch für den als Entladeschalter 81 in der Entladeschaltung 8 verwendeten Bipolartransistor mit isoliertem Gate. Dieser wird deshalb bevorzugt eingesetzt, da er sich durch eine hohe Durchbruchsspannung auszeichnet. Eine solche hohe Durchbruchsspannung ist insbesondere wegen der hohen auf der Sekundärseite auftretenden Spannungen wünschenswert.

Bei der in Figur 2 gezeigten Ausführungsform wird, wie erläutert, durch das konstante Referenzsignal des Referenzsignalgebers 76 eine Aufladung des Piezoelements 1 mit konstanten Ladungspulsen erreicht, wodurch sich ein wurzelförmiger Verlauf der Ladespannung am Piezoelement 1 einstellt. Bei der in Figur 1 gezeigten Endstufe besteht jedoch auch die Möglichkeit, andere zeitliche Verläufe der Spannung am Piezoelement 1 zu erzeugen.

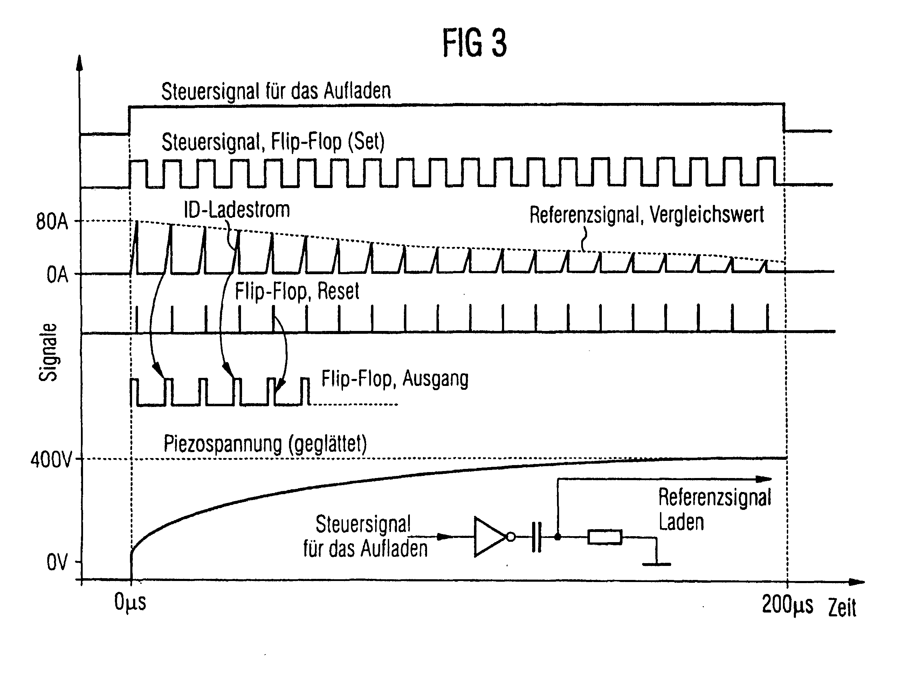

In Figur 3 sind die der Figur 2 entsprechenden Signalverläufe für einen Referenzsignalgeber 76 gezeigt, der als RC-Glied ausgebildet ist. Dieses RC-Glied setzt sich aus einem Inverter 761, einen Kondensator 762 und einen Widerstand 763 zusammen, die in Reihe geschaltet sind, wobei das Referenzsignal zwischen dem Kondensator 762 und dem Widerstand 763 abgegriffen wird. Diese Schaltung führt zu einem exponentiell abnehmenden Verlauf des Referenzsignals und damit zu einem logarithmisch ansteigenden Verlauf der Ladespannung am Piezoelement 1, wie Figur 3 zeigt. Durch diese Ausgestaltung wird erreicht, dass mit dem Fly-Back-Konverter mit pulsweiten-modulierten Signal das Verhalten einer RC-Endstufe nachgestellt wird.

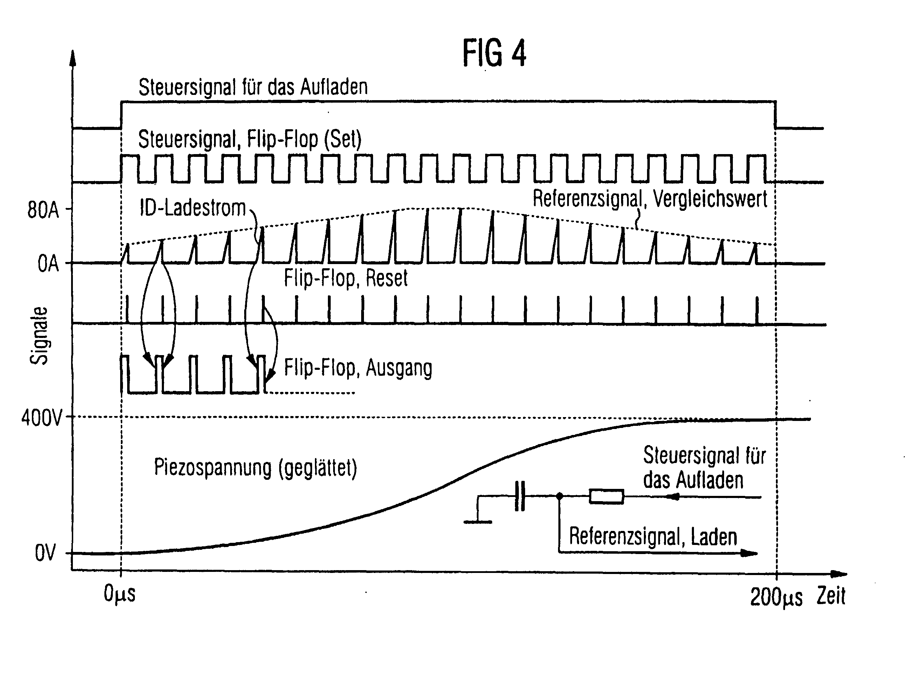

Figur 4 zeigt eine weitere mögliche Ausgestaltung, bei der der Referenzsignalgeber 76 als RC-Glied ausgestaltet ist. Hierbei sind eine Spule 764 und ein Kondensator 765 in Reihe geschaltet, wobei das Referenzsignal zwischen der Spule 764 und dem Kondensator 765 abgegriffen wird. Hierdurch ergibt sich ein im Wesentlichen cosinus-förmiger Verlauf des Referenzsignals, wodurch ein sinus-förmiger Verlauf der Ladespannung des Piezoelements 1 erzeugt wird. Der Fly-Back-Konverter bildet somit eine LC-Endstufe nach.

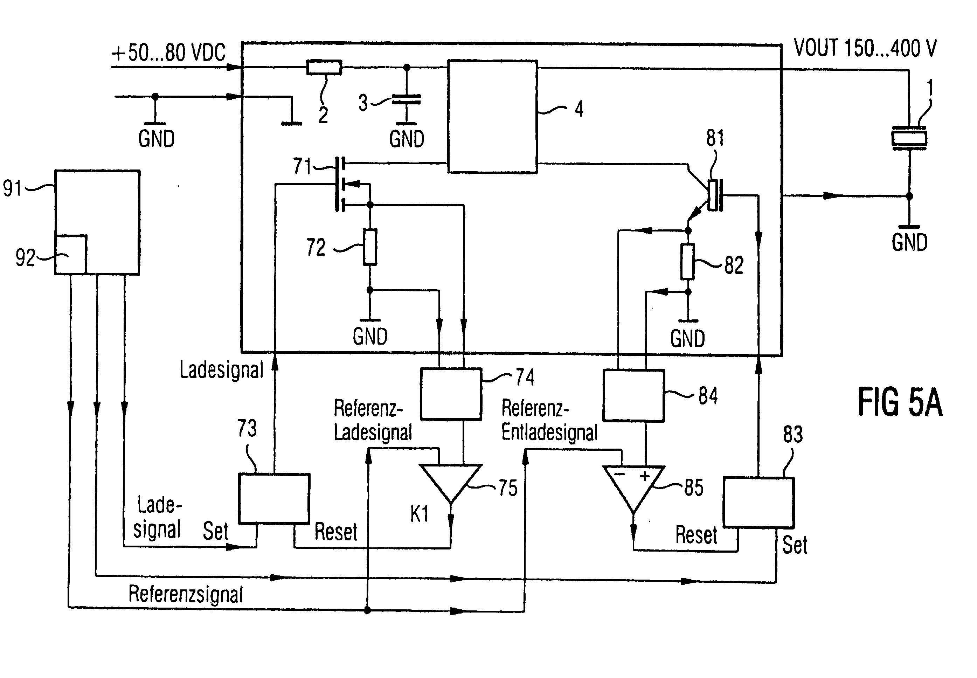

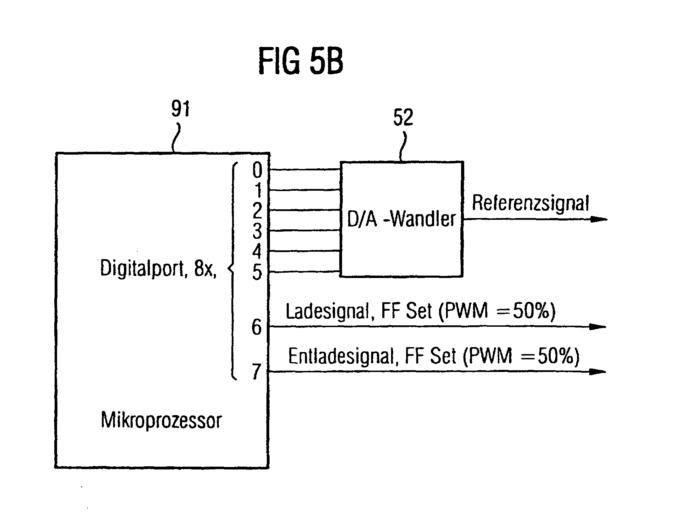

Die Verwendung von Hochpassfiltern als Referenzsignalgeber 76, wie in Figur 3 und Figur 4 gezeigt, erlaubt jedoch nur eine begrenzte Anzahl von Kurvenformen der Ladespannung bzw. Entladespannung am Piezoelement 1 zu erzeugen. Gemäß einer weiteren Ausführungsform, die in Figur 5A gezeigt ist, kann deshalb der Referenzsignalgeber als Digital/Analog-Wandler 92 ausgestaltet sein, der von einem Mikroprozessor 91 angesteuert wird, um Referenzsignale mit beliebigen Kurvenformen zu erzeugen. Die Ankopplung des Mikroprozessors 91 an den Digital/Analog-Wandler 92 kann dabei, wie in Figur 5B gezeigt ist, mit einem einzigen 8-Bit-Port erfolgen. Der wesentliche Vorteil dieser Anordnung liegt darin, dass der Mikroprozessor 91 nicht selbst die pulsweiten-modulierten Signale mit bei jedem Puls neu kalkulierten Tastverhältnis erzeugt, sondern bei jedem Puls einen Digitalwert an den Digital/Analog-Wandler 92 ausgibt, der dann ein dem Digitalwert entsprechendes Referenzsignal erzeugt. Der Mikroprozessor 91 kann dabei auch zusätzlich die Steuersignale für den Lade-Flip-Flop 73 bzw. den Entlade-Flip-Flop 83 generieren, da diese Signale als einfache pulsweiten-modulierte Signale z. B. mit einem 50-%-Tastverhältnis ausgestaltet sind.

Wie Figur 5A zeigt, kann der vom Mikroprozessor 91 gesteuerte Digital/Analog-Wandler 92 als gemeinsamer Referenzsignalgeber sowohl für die Ladeeinrichtung 7 als auch für die Entladeeinrichtung 8 eingesetzt werden, da diese beiden Signale ja nur zu unterschiedlichen Zeitpunkten benötigt werden. Bei der in Figur 5A gezeigten Ausführungsform ist eine der Ladeeinrichtung 7 entsprechende Entladeeinrichtung 8 mit dem Entlade-Flip-Flop 83, einem Strommesswiderstand 82, einem Tiefpassfilter 84 und einem Komparator 85 gezeigt. Die in Figur 5A gezeigte Vorrichtung arbeitet dabei prinzipiell ähnlich wie die in Figur 1 gezeigte Endstufe.

Durch die erfindungsgemäße Ausgestaltung einer Vorrichtung zum variablen Ansteuern eines kapazitiven Stellgliedes als Fly-Back-Konverter mit einem Transformator bei dem das Tastverhältnis der pulsweiten-modulierten Signale zum Ansteuern des Lade- bzw. Entladetransistors über eine Messung der jeweiligen Ströme erfolgt, ist es möglich, beliebige Formen der Lade- bzw. Entladespannung am kapazitiven Stellglied zu erreichen. Eine solche Vorrichtung eignet sich insbesondere als Endstufe für einen Piezoaktor.

## Patentansprüche

1. Vorrichtung zum variablen Ansteuern wenigstens eines kapazitiven Stellgliedes, insbesondere eines Piezoelements (1) in einem Kraftstoffinjektor, mit einem von einer Energiequelle (2) auf ein bezüglich eines Bezugspotentials vorgegebene Spannung aufladbaren Ladenkondensator (3),wobei
- parallel zum Ladekondensator (3) eine Reihenschaltung der Primärspule (41) eines Transformators (4) und einer Ladeeinrichtung (7) angeordnet ist,
- die Sekundärspule (42) des Transformators (4) mit einer Entladeinrichtung (8) und dem kapazitiven Stellglied (1) in Reihe geschaltet ist.
- parallel zur Ladeeinrichtung (7) ein vom Bezugpotential (GND) weg stromleitendes Element (51) und parallel zur Entladeeinrichtung (8) ein vom Bezugspotential (GND) weg stromleitendes Element (8) geschaltet ist,
- die Ladeeinrichtung (7) und/oder Entladeeinrichtung 88) einen Schalter 871, 81), eine zwischen dem Schalter und dem Bezugspotential angeordnete Messeinrichtung (72, 82) zum Bestimmen des über den Schalter fließenden Stroms, einen Referenzsignalgeber (76, 92) zum Erzeugen eines Referenzstromwerte darstellenden Signalverlaufs, eine Vergleichseinrichtung (75, 85) zum Vergleichen des gemessenen Stromwertes mit dem Referenzsignal und eine Steuereinrichtung (73, 81) mit einem pulsweiten-modelierten Signal, um den Schalter in einen leitenden Zustand zu schalten, aufweist, wobei das Tastverhältnis des einem pulsweiten-modelierten Signals so bestimmt wird, dass der Schalter (71, 81) so lange leitend bleibt, bis die Vergleichseinrichtung (75, 85) feststellt, dass der gemessene Stromwert dem Referenzsignal entspricht, und wobei der Referenzsignalgeber (76) ein Hochpassfilter zum Erzeugen eines von einem konstanten Wert abweichenden Referenzsignalverlaufs aufweist.

2. Vorrichtung nach Anspruch 1, **dadurch gekennzeichnet, dass** die Steuereinrichtung (73, 83) ein Flip-Flop zum Ansteuern des Schalters (71, 81) aufweist, wobei das Flip-Flop von einem konstanten Steuersignal getriggert wird und von der Vergleichseinrichtung (75, 85) zurückgesetzt wird, wenn der gemessene Stromwert dem Referenzsignal entspricht.

3. Vorrichtung nach Anspruch 1, **dadurch gekennzeichnet, dass** der Referenzsignalgeber (76) ein RC-Glied zum Erzeugen eines logarithmischen Verlaufes der Lade- bzw. Entladespannung am kapazitiven Stellglied (1) aufweist.

4. Vorrichtung nach Anspruch 1, **dadurch gekennzeichnet, dass** der Referenzsignalgeber 876) ein RC-Glied zum Erzeugen eines sinusförmigen Verlaufes der Lade- bzw. Entladespannung am kapazitiven Stellglied (1) aufweist.

5. Vorrichtung nach Anspruch 1, **dadurch gekennzeichnet, dass** der Referenzsignalgeber (76) einen Digital/Analog-Wandler (2) aufweist, der von einem Mikroprozessor (91) angesteuert wird, um den Referenzsignalverlauf zu erzeugen.

6. Vorrichtung nach Anspruch 1, **dadurch gekennzeichnet, dass** die Ladeeinrichtung (7) und die Entladeeinrichtung (8) einen gemeinsamen Referenzsignalgeber aufweisen.

7. Vorrichtung nach Anspruch 1, **dadurch gekennzeichnet, dass** parallel zum Transformator 84) ein Snubber-Netzwerk geschaltet ist, um die durch Streuinduktivität im Transformator (4) erzeugten Spannungsspitzen zu dämpfen.

## Claims

1. Arrangement for variably driving a capacitive actuator, more specifically a piezoelectric element (1) in a fuel injector, having a charging capacitor (3) which can be charged to a predetermined voltage relative to reference potential by an energy source (2),
- there being disposed in parallel with the charging capacitor (3) a series circuit comprising the primary coil (41) of a transformer (4) and a charging device (7),
- the secondary coil (42) of the transformer (4) being connected in series with a discharging device (8) and the capacitive actuator (1),
- there being connected in parallel with the charging device (7) an element (51) conducting current away from the reference potential (GND) and, in parallel with the discharging device (8), an element (52) conducting current away from the reference potential (GND),
- the charging device (7) and/or discharging device (8) having a switch (71, 81), a measuring device (72, 82) disposed between the switch and the reference potential for determining the current flowing via the switch, a reference signal generator (76, 92) for producing a signal waveform representing reference current values, a comparison device (75, 85) for comparing the measured current value with the reference signal and a control device (73, 83) for driving the switch (71, 81) with a pulse-width modulated signal in order to render the switch conducting, the duty cycle of the pulse-width modulated signal being determined in such a way that the switch (71, 81) remains conducting until the comparison device (75, 85) establishes that the measured current value corresponds to the reference signal, and the reference signal generator (76) having a high-pass filter for producing a reference signal waveform deviating from a constant value.

2. Arrangement according to Claim 1, **characterised in that** the control device (73, 83) has a flip-flop for driving the switch (71, 81), the flip-flop being triggered by a constant control signal and reset by the comparison device (75, 85) when the measured current value corresponds to the reference signal.

3. Arrangement according to Claim 1, **characterised in that** the reference signal generator (76) has an RC element for generating a logarithmic waveform of the charging or discharging voltage across the capacitive actuator (1).

4. Arrangement according to Claim 1, **characterised in that** the reference signal generator (76) has an RC element for generating a sinusoidal waveform of the charging or discharging voltage across the capacitive actuator (1).

5. Arrangement according to Claim 1, **characterised in that** the reference signal generator (76) has a digital/analogy converter (2) controlled by a microprocessor (91) in order to generate the reference signal waveform.

6. Arrangement according to Claim 1, **characterised in that** the charging device (7) and the discharging device (8) have a common reference signal generator.

7. Arrangement according to Claim 1, **characterised in that** a snubber network for suppressing voltage spikes caused by stray inductance in the transformer (4) is connected in parallel with the transformer (4).

## Revendications

1. Dispositif pour commander l'enclenchement de façon variable d'au moins un organe de réglage capacitif, en particulier d'un élément piézo-électrique (1) dans un injecteur de carburant, comportant un condensateur de charge (3) pouvant être chargé par une source d'énergie (2) à une tension prédéfinie conformément à un potentiel de référence, dans lequel :
- un circuit en série de la bobine primaire (41) d'un transformateur (4) et d'un dispositif de charge (7) est disposé en parallèle avec le condensateur de charge (3),
- la bobine du secondaire (42) du transformateur (4) est connectée en série à un dispositif de décharge (8) et à l'organe de réglage capacitif (1),
- un élément (51) conducteur du courant, partant du potentiel de référence (GND), est connecté en parallèle avec le dispositif de charge (7), et un élément (8) conducteur de courant, dérivant du potentiel de référence (GND), est connecté en parallèle avec le dispositif de décharge (8),
- le dispositif de charge (7) et/ou le dispositif de décharge (8) présente un commutateur (71, 81), un dispositif de mesure (72, 82), disposé entre le commutateur et le potentiel de référence, pour déterminer le courant s'écoulant par le commutateur, un émetteur de signal de référence (76, 92) pour produire une courbe d'évolution d'un signal représentant une valeur d'intensité de référence, un dispositif de comparaison (75, 85) pour comparer la valeur mesurée de l'intensité au signal de référence, et un dispositif de commande (73, 81) comportant un signal modulé en impulsions en largeur, pour commuter le commutateur en position conductrice, le taux d'impulsion de l'un des signaux modulés en impulsions en largeur étant déterminé de telle façon que le commutateur (71, 81) reste conducteur, jusqu'à ce que le dispositif de comparaison (75, 85) détermine que la valeur mesurée de l'intensité correspond au signal de référence, et l'émetteur de signal de référence (76) présentant un filtre passe-haut pour produire une courbe d'évolution de signal de référence s'écartant d'une valeur constante.

2. Dispositif suivant la revendication 1, **caractérisé en ce que** le dispositif de commande (73, 83) présente un flip-flop pour actionner le commutateur (71, 81), le flip-flop étant déclenché par un signal de commande constant et rappelé en position initiale par le dispositif de comparaison (75, 85) si la valeur d'intensité mesurée correspond au signal de référence.

3. Dispositif suivant la revendication 1, **caractérisé en ce que** l'émetteur de signal de référence (76) présente un élément RC (résistance-capacité) pour produire une courbe d'évolution logarithmique des tensions respectives de charge et de décharge sur l'organe de réglage capacitif (1).

4. Dispositif suivant la revendication 1, **caractérisé en ce que** l'émetteur de signal de référence (76) présente un élément résistance-capacité pour produire une courbe d'évolution en forme de sinus respectivement pour la tension de charge et la tension de décharge sur l'organe de réglage capacitif (1).

5. Dispositif suivant la revendication 1, **caractérisé en ce que** l'émetteur de signal de référence (76, 92) présente un convertisseur numérique-analogique (2) qui est commandé par un microprocesseur (91) pour produire la courbe d'évolution d'un signal de référence.

6. Dispositif suivant la revendication 1, **caractérisé en ce que** le dispositif de charge (7) et le dispositif de décharge (8) présentent un émetteur commun des signaux de référence.

7. Dispositif suivant la revendication 1, **caractérisé en ce qu'**un réseau de Snubber est connecté en parallèle avec le transformateur (4) pour amortir les pointes de tension produites par inductances de fuite dans le transformateur (4).
